(19) Europäisches Patentamt
European Patent Office
Office européen des brevets

(11) EP 3 089 366 B1

(12) EUROPEAN PATENT SPECIFICATION

(45) Date of publication and mention of the grant of the patent:
**29.09.2021 Bulletin 2021/39**

(51) Int Cl.:
***H03H 11/12*** (2006.01) ***H03F 3/45*** (2006.01)
***G05F 3/26*** (2006.01)

(21) Application number: **15190380.4**

(22) Date of filing: **19.10.2015**

(54) **FREQUENCY SELECTIVE CIRCUIT**

FREQUENZSELEKTIVE SCHALTUNG

CIRCUIT SÉLECTIF DE FRÉQUENCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.04.2015 US 201562153622 P**
**10.08.2015 US 201514821885**

(43) Date of publication of application:
**02.11.2016 Bulletin 2016/44**

(73) Proprietor: **MediaTek Inc.**
**Hsin-Chu 300 (TW)**

(72) Inventors:
- **Chung, Yuan-Hung**
  **302 Zhubei City, Hsinchu County (TW)**
- **Hsu, Ming-Yeh**
  **333 Taoyuan City (TW)**

(74) Representative: **Krauns, Christian**
**Wallinger Ricker Schlotter Tostmann**
**Patent- und Rechtsanwälte Partnerschaft mbB**
**Zweibrückenstraße 5-7**
**80331 München (DE)**

(56) References cited:
**US-A1- 2011 090 824 US-A1- 2012 098 574**
**US-B1- 7 218 170**

- **RAMIREZ-ANGULO J ET AL: "Compact implementation of high-performance CMOS current mirror", ELECTRONICS LETTERS, IEE STEVENAGE, GB, vol. 41, no. 10, 12 May 2005 (2005-05-12), pages 570-572, XP006024037, ISSN: 0013-5194, DOI: 10.1049/EL:20051122**
- **SANCHEZ-SINENCIO E ET AL: "CMOS TRANSCONDUCTANCE AMPLIFIERS, ARCHITECTURES AND ACTIVE FILTERS:A TUTORIAL", IEE PROCEEDINGS: CIRCUITS DEVICES AND SYSTEMS, INSTITUTION OF ELECTRICAL ENGINEERS, STENVENAGE, GB, vol. 147, no. 1, 1 February 2000 (2000-02-01), pages 3-12, XP000937151, ISSN: 1350-2409, DOI: 10.1049/IP-CDS:20000055**
- **WANG Z ED - COURTOIS BERNARD: "CURRENT-MODE LOWPASS FILTERS IN CMOS TECHNOLOGY", MICROELECTRONICS JOURNAL, MACKINTOSH PUBLICATIONS LTD. LUTON, GB, vol. 23, no. 6, 1 September 1992 (1992-09-01), pages 479-481, XP000311488, ISSN: 0026-2692, DOI: 10.1016/0026-2692(92)90082-C**
- **None**

EP 3 089 366 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### TECHNICAL FIELD

The disclosure relates in general to a frequency selective circuit.

### BACKGROUND

In modern circuit designs, the frequency selective circuit, such as the low pass filter (LPF), is an indispensable block for filtering signals. For example, an inphase/quadrature modulator (IQM) may cooperate with a simple LPF cascaded by passive RC (resistor, capacitor) filters to generate signals to be transmitted. Once the frequency of unwanted signal is close to the desired signal, such LPF cannot provide enough rejections because of the low Q.

The US 2011/090824 A1 discloses techniques for low-pass filtering with high quality factor. The input current is coupled to the drain of a first transistor. The drain and the gate of the first transistor are coupled together by a resistor, and the drain is coupled to a reference voltage by a first capacitor. The gate is coupled to a reference voltage by a second capacitor. The gate is further coupled to the gate of a second transistor, and an output current is coupled to the drain of the second transistor. Further passive elements are coupled to generate an odd-order low-pass transfer characteristic. Multiple filters are cascaded in series to synthesize a filter having arbitrary order.

The US 2012/0098574 A1 discloses a current-mode filter including a first, a second, and a third transistor having the same channel polarity. The drain of the first transistor is connected to the source of the second transistor functioning as a gate grounded circuit. The drain of the second transistor is connected to the gates of the first and third transistors. A first and a second capacitive element are connected to the gate and drain of the first transistor. The current source supplies a bias current to each of the first and second transistors. The drain of the first transistor is used as an input terminal. An output signal is extracted from a drain current of the third transistor.

J. Ramirez-Angulo et al. disclose a plurality of CMOS integrated circuits in the document entitled "Compact Implementation of high-performance CMOS current mirror", Electronics Letters, IEE Stevenage, GB, vol. 41, no. 10, 2005.

E.Sanchez-Sinencio et al. disclose active filters using CMOS transconductance amplifiers in the document entitled "CMOS transconductance amplifiers, architectures and active filters: a tutorial" IEE Proceedings: Circuits Devices and Systems, Institution of Electrical Engineers, Stevenage, GB, vol. 147, no. 1, 2000.

For getting better rejections, the designer needs to cascade more stages of RC filters, which occupied larger area, generates lager output noise and may corrupt the desired signal.

Therefore, there is a need of a frequency selective circuit capable of performing high Q filtering and reducing the output noise.

### SUMMARY

The disclosure is directed to a frequency selective circuit capable of performing high Q filtering and reducing the output noise.

The object of the present invention is solved by a frequency selective circuit according to the independent claim 1. The dependent claim refers to an advantageous embodiment.

### BRIEF DESCRIPTION OF THE DRAWINGS

FIG. 1 shows the circuit diagram of a frequency selective circuit useful for the understanding of the present invention.
FIG. 2 shows the circuit diagram of a frequency selective circuit according to an embodiment of the present invention.
FIG. 3 shows the circuit diagram of a frequency selective circuit useful for the understanding of the present invention.
FIG. 4 shows the circuit diagram of a frequency selective circuit useful for the understanding of the present invention.
FIG. 5 shows the circuit diagram of a frequency selective circuit useful for the understanding of the present invention.
FIG. 6 shows the circuit diagram of a frequency selective circuit useful for the understanding of the present invention.
FIG. 7 shows the circuit diagram of a frequency selective circuit useful for the understanding of the present invention.
FIG. 8 shows the circuit diagram of a frequency selective circuit useful for the understanding of the present invention.
FIG. 9 shows the circuit diagram of a frequency selective circuit useful for the understanding of the present invention.
FIG. 10 shows the circuit diagram of a frequency selective circuit useful for the understanding of the present invention.
FIG. 11 shows the circuit diagram of a frequency selective circuit useful for the understanding of the present invention.
FIGS. 12A to 12C illustrate different source degeneration types.
FIG. 13 illustrates the circuit diagram of a frequency selective circuit that the first transistor is diode-connected and

a 2nd order LPF is coupled between the gates of the first and second transistors.

FIG. 14A illustrates a simulated frequency response of a Butterworth filter implemented by the proposed frequency selective circuit.

FIG. 14B illustrates a simulated frequency response of a low pass filter implemented by the frequency selective circuit shown in FIG. 13.

FIG. 15 shows the block diagram of a transmitter which may incorporate a frequency selective circuit according to an embodiment

of the present invention.

FIG. 16 shows the block diagram of a receiver which may incorporate a frequency selective circuit according to an embodiment of the present invention.

FIG. 17 shows the block diagram of a receiver which may incorporate a frequency selective circuit according to an alternative embodiment of the present invention.

In the following detailed description, for purposes of explanation, numerous specific details are set forth in order to provide a thorough understanding of the disclosed embodiments. In other instances, well-known structures and devices are schematically shown in order to simplify the drawing.

DETAILED DESCRIPTION

Below, exemplary embodiments will be described in detail with reference to accompanying drawings so as to be easily realized by a person having ordinary knowledge in the art. Descriptions of well-known parts are omitted for clarity, and like reference numerals refer to like elements throughout.

FIG. 1 shows the circuit diagram of a frequency selective circuit 100 as an example not falling within the scope of the invention, yet useful for the understanding of the present invention. The frequency selective circuit 100 includes a first transistor $M_1$, an impedance element ZA1, a first capacitive element $C_1$, a second capacitive element $C_2$ and a second transistor $M_2$. The impedance element ZA1 includes a resistive element such as the resistor $R_1$. The impedance element ZA1 is coupled between the drain and gate of the first transistor $M_1$. The first capacitive element $C_1$ is coupled to the drain of the first transistor $M_1$. The gate of the first transistor $M_1$ is coupled to the second capacitive element $C_2$ and the gate of the second transistor $M_2$. The first and second capacitive elements $C_1$ and $C_2$ can be implemented by capacitors for example.

The drain of the first transistor $M_1$ is further coupled to the input current $I_i$, and thus a control voltage $V_o$ is induced on the gate of the second transistor $M_2$. In response to the control voltage $V_o$, the second transistor $M_2$ generates the output current $I_o$ at its drain.

The transfer function of the frequency selective circuit 100 can be expressed as follows:

$$H(s)=\frac{g_{m2}}{g_{m1}}\times\frac{1}{1+\frac{C_1+C_2}{g_{m1}}s+\frac{R_1C_1C_2}{g_{m1}}s^2} \quad \text{(eq1)}$$

wherein $H(s)$ represents the transfer function from the input current $I_i$ to the output current $I_0$, $g_{m1}$ and $g_{m2}$ represent the transconductances of the first and second transistors $M_1$ and $M_2$, respectively, $C_1$ and $C_2$ represent the capacitances of the first and second capacitive elements $C_1$ and $C_2$, respectively, and $R_1$ represents the resistance of the resistor $R_1$. According to equation eq1, the frequency selective circuit 100 can be regarded as a 2nd order current-mode filter. By appropriately selecting the values of the parameters shown in equation eq1, the Q-factor can be larger than 0.5. That is, the frequency selective circuit 100 is capable of perform a high Q filtering. Further, it can be obtained from FIG. 1 that, an additional cascode stage is unnecessary for the frequency selective circuit 100, and hence the voltage headroom can be enlarged.

In the present invention, the impedance element coupled to the first transistor is composed of a resistive element (e.g. a resistor) and an inductive element (e,.g. an inductor) connected in series. FIG. 2 shows the circuit diagram of a frequency selective circuit 200 according to an embodiment of the present invention. For illustration purposes, denotations in FIG. 2 that are same as those in FIG. 1 represent elements, materials or substances that are functionally identical or similar, and associated details are omitted herein. However, the above is not to be construed as a limitation to the present invention. In other embodiments, elements with the same denotations may be implemented by different circuits, materials or structures.

In FIG. 2, the impedance element ZA2 includes a resistor $R_1$ and an inductor $L_1$ in series. The transfer function of the frequency selective circuit 200 can be expressed as follows:

$$H(s)=\frac{g_{m2}}{g_{m1}}\times\frac{1}{1+\frac{C_1+C_2}{g_{m1}}s+\frac{(R_1+sL_1)C_1C_2}{g_{m1}}s^2} \qquad \text{(eq2)}$$

wherein $L_1$ represents the inductance of the inductor $L_1$. As can be seen from equation eq2, the inductor $L_1$ provides one more pole at frequency $\omega_{PL} = R_1/L_1$. Thus, the out-band rejections of the frequency selective circuit 200 can be further improved by appropriately choosing the pole frequency $\omega_{PL}$.

FIG. 3 shows the circuit diagram of a frequency selective circuit 300 according to an an example not falling within the scope of the invention. The main difference between the frequency selective circuit 300 and the frequency selective circuit 200 shown in FIG. 2 is that the impedance element ZA3 includes inductor(s) $L_1$ only.

The frequency selective circuit may cascade multiple sub-circuits to perform high-order filtering. FIG. 4 shows the circuit diagram of a frequency selective circuit 400 as an example not falling within the scope of the claims, yet useful for the understanding of the present invention. The frequency selective circuit 400 includes multiple sub-circuits 402 cascaded between the gates of the first and second transistors $M_1$ and $M_2$. The sub-circuits 402 can be implemented by various types of filters. For example, in FIG. 4, each sub-circuit 402 includes a RC filter.

The simplified transfer function of the frequency selective circuit 400 can be expressed as follows:

$$H(s)=\frac{g_{m2}}{g_{m1}}\times\frac{1}{1+\frac{C_1+C_2}{g_{m1}}s+\frac{R_1C_1C_2}{g_{m1}}s^2}\times\frac{1}{1+R_2C_3s}\times\cdots\times\frac{1}{1+R_{n-1}C_ns} \qquad \text{(eq3)}$$

wherein $C_3$ to $C_n$ respectively represent the capacitances of the capacitors $C_3$ to $C_n$, and $R_2$ to $R_{n-1}$ respectively represent the resistances of the resistors $R_2$ to $R_{n-1}$.

FIG. 5 shows the circuit diagram of a frequency selective circuit 500 as an example not falling within the scope of the claims, yet useful for the understanding of the present invention. The frequency selective circuit 500 employs the multiple sub-circuits 502 in its impedance element ZA5. As shown in FIG. 5, the impedance element ZA5 includes multiple sub-circuits 502 cascaded in series. Similar to the sub-circuits 402 shown in FIG. 4, each sub-circuit 502 can be formed by a RC filter, but it is understood that the present is not limited thereto.

The simplified transfer function of the frequency selective circuit 500 can be expressed as follows:

$$H(s)=\frac{g_{m2}}{g_{m1}}\times\frac{1}{1+(\frac{C_1+C_2}{g_{m1}}s+\frac{R_1C_1C_2}{g_{m1}}s^2)\times(1+R_2C_3s)\times\cdots\times(1+R_{n=1}C_ns)} \qquad \text{(eq4)}$$

FIG. 6 shows the circuit diagram of a frequency selective circuit 600 as an example not falling within the scope of the claims, yet useful for the understanding of the present invention. The impedance element ZA6 of the frequency selective circuit 600 further includes a third transistor $M_3$ for a low input swing design. As shown in FIG. 6, the drain of the third transistor $M_3$ is coupled to the gate of the first transistor $M_1$ via the resistor $R_1$. The source of the third transistor $M_3$ is coupled to the drain of the first transistor $M_1$. The gate of the third transistor $M_3$ is biased by a reference voltage $V_b$.

The transfer function of the frequency selective circuit 600 can be expressed as follows:

$$H(s)=\frac{g_{m2}}{g_{m1}}\times\frac{1}{1+\frac{C_1+C_2}{g_{m1}}s+\frac{R_1C_1C_2}{g_{m1}}s^2} \qquad \text{(eq5)}$$

Compared to equation eq1, it can be obtained that the transfer function of the frequency selective circuit 600 remains the same. However, since the input swing can be determined by the transconductance of the third transistor $M_3$, without affecting the designed frequency response, the third transistor $M_3$ actually provides an extra degree of circuit design freedom, such that the low input swing design can be achieved.

FIG. 7 shows the circuit diagram of a frequency selective circuit 700 as an example not falling within the scope of the claims, yet useful for the understanding of the present invention. The main difference between the frequency selective circuit 700 and the frequency selective circuit 600 shown in FIG. 6 is that the resistor $R_1$ is removed from the impedance element ZA7.

The transfer function of the frequency selective circuit 700 can be expressed as follows:

$$H(s)=\frac{g_{m2}}{g_{m1}}\times\frac{1}{1+\frac{C_1}{g_{m1}}s+\frac{C_1C_2}{g_{m1}g_{m3}}s^2} \quad \text{(eq6)}$$

wherein $g_{m3}$ represents the transconductance of the third transistor $M_3$. Compared to the previous embodiments, the frequency selective circuit 700 has more design freedom since the first and second capacitive elements $C_1$ and $C_2$ are isolated by the third transistor $M_3$. Once the third transistor is biased at the linear region, the transfer function returns to eq1.

FIG. 8 shows the circuit diagram of a frequency selective circuit 800 as an example not falling within the scope of the claims, yet useful for the understanding of the present invention. Compared to the frequency selective circuit 600 shown in FIG. 6, the impedance element ZA8 of the frequency selective circuit 800 further includes an operational amplifier 802 to reduce the input swing. The operational amplifier 802 includes a first input, a second input and an output. The first input is coupled to the reference voltage $V_b$, the second input is coupled to the source of the third transistor $M_3$, and the output is coupled to the gate of the third transistor $M_3$.

Due to the virtual short between the first and second inputs of the operational amplifier 802, the voltage at the node (i.e., source of the third transistor $M_3$, or drain of the first transistor $M_1$) coupling to the input current $I_i$ is fixed and the input swing can be set to zero.

FIG. 9 shows the circuit diagram of a frequency selective circuit 900 as an example not falling within the scope of the claims, yet useful for the understanding of the present invention. The frequency selective circuit 900 employs CMOS inverter configuration at its input stage and output stage. For the input stage, the impedance element ZA9 of the frequency selective circuit 900 includes a first complementary transistor $M_{p1}$. The type of the first complementary transistor $M_{p1}$ is complementary to that of the first transistor $M_1$. For example, the first complementary transistor $M_{p1}$ is a P-type transistor when the first transistor $M_1$ is an N-type transistor, while is an N-type transistor when the first transistor $M_1$ is a P-type transistor. The first complementary transistor $M_{p1}$ and the first transistor $M_1$ are connected to each other based CMOS inverter configuration, wherein the drain of the first complementary transistor $M_{p1}$ is coupled to the drain of the first transistor $M_1$, and the gate of the first complementary transistor $M_{p1}$ is coupled to the gate and of the first transistor $M_1$. Similarly, for the output stage, the frequency selective circuit 900 includes a second complementary transistor $M_{p2}$ coupled to the second transistor $M_2$ and forming a CMOS inverter together with the second transistor $M_2$.

The impedance element ZA9 further includes a resistive element, e.g., the resistor $R_1$, coupled between the drain and gate of the first complementary transistor $M_{P1}$. The transfer function of the frequency selective circuit 900 can be expressed as follows:

$$H(s)=\frac{g_{M2}}{g_{M1}}\times\frac{1}{1+\frac{C_1+C_2}{g_{M1}}s+\frac{R_1C_1C_2}{g_{M1}}s^2} \quad \text{(eq7)}$$

wherein $g_{M1}$ is the equivalent transconductance of the transconductances of the first complementary transistor $M_{p1}$ and the first transistor $M_1$, and $g_{M2}$ is the equivalent transconductance of the transconductances of the second complementary transistor $M_{p2}$ and the second transistor $M_2$. Compared to the previous embodiments, the equivalent transconductances $g_{M1}$ and $g_{M2}$ are twice with the same current consumption.

FIG. 10 shows the circuit diagram of a frequency selective circuit 1000 as an example not falling within the scope of the claims, yet useful for the understanding of the present invention. The frequency selective circuit 1000 employs differential configuration at its input and output stages. As shown in FIG. 10, the frequency selective circuit 1000 includes an input differential pair 1002 at the input stage and an output differential pair 1004 at the output stage. The output differential pair 1004 may generate output currents $I_{op}$ and $I_{on}$ in response to the input currents lip and lin received from the input differential pair 1002.

The input differential pair 1002 includes two branches $B_{i1}$ and $B_{i2}$. The branch $B_{i1}$ includes a transistor $M_{1p}$, a resistor $R_{1P}$ and a capacitor $C_{2p}$. The drain of the transistor $M_{1p}$ is coupled to its gate via the resistor $R_{1P}$, and the gate of the transistor $M_{1P}$ is further coupled to the capacitor $C_{2p}$. Similarly, the branch $B_{i2}$ includes a transistor $M_{1n}$, a resistor $R_{1n}$ and a capacitor $C_{2n}$. The drain of the transistor $M_{1n}$ is coupled to its gate via the resistor $R_{1n}$, and the gate of the transistor $M_{1n}$ is further coupled to the capacitor $C_{2n}$. A capacitor $C_1$' is coupled between the drains of the transistors $M_{1p}$ and $M_{1n}$.

The input differential pair 1002 can be regarded as a differential form of the left part of the frequency selective circuit 100 shown in FIG. 1. That is, the first transistor $M_1$, the impedance element ZA1 and the second capacitive element $C_2$ can be used to form one branch $B_{i1}$/ $B_{i2}$ of the input differential pair 1002, and the branch $B_{i1}$/ $B_{i2}$ is coupled to the paired branch $B_{i2}$/ $B_{i1}$ via the first capacitive element $C_1$.

The output differential pair 1004 includes two branches $B_{o1}$ and $B_{o2}$. The branch $B_{o1}$ includes a transistor $M_{2p}$ to induce the output current $I_{op}$, and the branch $B_{o2}$ includes a transistor $M_{2n}$ to induce the output current $I_{on}$. Also, the output differential pair 1004 can be regarded as the differential form of the right part of the frequency selective circuit 100. In other words, the second transistor $M_2$ can be used to form one branch $B_{o1}$/ $B_{o2}$ of the output differential pair 1004, and the branch $B_{o1}$/ $B_{o2}$ is coupled to the paired branch $B_{o2}$/ $B_{o1}$ via the source of the second transistor $M_2$.

The transfer function of the frequency selective circuit 1000 has the same form as that of the frequency selective circuit 100 shown in FIG. 1, but the capacitance of the capacitor $C_1$' can be half of $C_1$.

FIG. 11 shows the circuit diagram of a frequency selective circuit 1100 as an example not falling within the scope of the claims, yet useful for the understanding of the present invention. In this embodiment, two branches $B_{i1}$' and $B_{i2}$' of the input differential pair 1102 are coupled to each other further via a capacitor $C_2$'. As shown in FIG. 11, the gate of the transistor $M_{1p}$ is coupled to the gate of the transistor of $M_{1n}$ via the capacitor $C_2$'. The transfer function of the frequency selective circuit 1100 has the same form as equation eq1, and the capacitance of the capacitor $C_2$' can be half of the capacitance of the capacitor $C_2$.

In some of the above-described circuits, the source degeneration technique can be used to improve the linearity of the circuit. As shown in FIG. 12A, the source of the first/second transistor $M_1/M_2$ is coupled to a degeneration resistive element $R_d$. For a differential pair, two degeneration resistive elements $R_{dp}$ and $R_{dn}$ can be added to the sources of the transistors $M_{1P}/M_{2P}$ and $M_{1n}/M_{2n}$, respectively, as shown in FIG. 12B. Alternatively, the sources of the transistors $M_{1P}/M_{2P}$ and $M_{1n}/M_{2n}$ can be commonly coupled to the same degeneration resistive element $R_d$, as shown in FIG. 12C.

FIG. 13 illustrates the circuit diagram of a frequency selective circuit 1300 that the first transistor M1 is diode-connected and a 2$^{nd}$ order LPF 1302 is coupled between the gates of the first and second transistors $M_1$ and $M_2$. The transfer function of the frequency selective circuit 1300 can be expressed as follows:

$$H(s)=\frac{g_{m2}}{g_{m1}}\times\frac{1}{1+\frac{C_1+C_2+g_{m1}R_1C_2}{g_{m1}}s+\frac{R_1C_1C_2}{g_{m1}}s^2} \qquad \text{(eq8)}$$

If the term $g_{m1}R_1$ >>1, equation eq8 can be simplified to

$$H(s)=\frac{g_{m2}}{g_{m1}}\times\frac{1}{(1+\frac{1}{g_{m1}}C_1s)(1+R_1C_2s)} \qquad \text{(eq9)}$$

From equation eq9, it can be derived that the Q-factor is smaller than 0.5, which could not provide large rejection. In addition, for the frequency selective circuit 1300, the output noise induced by the resistor $R_1$ is

$$I_o=H(s)\times(g_{m1}+sC_1)\times\sqrt{4k'R_1} \qquad \text{(eq10)}$$

wherein *k*' is a constant associated to temperature.

For comparison, it can be derived that the output noise induced by the resistor $R_1$ of the frequency selective circuit 100 is expressed as follows:

$$I_o = H(s) \times sC_1 \times \sqrt{4k' R_1} \quad \text{(eq11)}$$

It can be found that the in-band output noise of the frequency selective circuit 100 is much smaller than that of the frequency selective circuit 1300, which proves that the proposed frequency selective circuit has better noise reduction performance.

FIG. 14A illustrates a simulated frequency response of a Butterworth filter implemented by the proposed frequency selective circuit. FIG. 14B illustrates a simulated frequency response of a low pass filter implemented by the frequency selective circuit shown in FIG. 13. As can be seen from these figures, the rejection at 64MHz of the proposed frequency selective circuit is at least 7dB better than that of the frequency selective circuit 1300, and the in-band roll-off of the proposed frequency selective circuit is also smaller.

The proposed frequency selective circuit can be used in various electronic devices. FIG. 15 shows the block diagram of a transmitter (TX) 1500 which may incorporate a frequency selective circuit according to an embodiment of the present invention. The TX 1500 includes a digital-to-analog converter (DAC) 1502, a current mode filter (CMF) 1504, an inphase/quadrature modulator (IQM) 1506, a driving amplifier (DA) 1508 and a power amplifier (PA) 1510 and an antenna 1512. The CMF 1504 can be implemented by any of the proposed frequency selective circuits and is used as a TX baseband filter. With the help of the proposed frequency selective circuit, high Q filtering without any extra current consumption can be achieved.

FIG. 16 shows the block diagram of a receiver (RX) 1600 which may incorporate a frequency selective circuit according to an embodiment of the present invention. The RX 1600 includes an antenna 1602, a low noise amplifier (LNA) 1604, a mixer 1606, a CMF 1610, a tansimpedance amplifier (TIA) 1610 and an analog-to-digital converter 1612. The CMF 1608 can be implemented by any of the frequency selective circuits described above and is used as a RX baseband filter.

In conventional passive-mixer based RX, the current-mode signal needs to be transferred to voltage domain by the TIA. In the embodiment, the CMF 1610 is placed before the TIA 1610, which relaxes the TIA design and improves the current consumption.

FIG. 17 shows the block diagram of a RX 1700 which may incorporate a frequency selective circuit according to an embodiment of the present invention. The RX 1700 further includes a CMF 1702 cooperating with the LNA 1604. The CMF 1702 can be implemented by any of the proposed frequency selective circuits described above, and is used as a radio frequency (RF) filter based on the naturally wideband characteristic from current mode. In one embodiment, the CMF 1702 can be embedded into the LNA 1604 and co-designed together.

**Claims**

1. A frequency selective circuit, wherein the frequency selective circuit comprises:

   a first transistor ($M_1$) comprising a drain terminal, a source terminal connected to ground and a gate terminal;
   an impedance element (R1+L1) coupled between the drain terminal and the gate terminal of the first transistor ($M_1$);
   a first capacitive element ($C_1$) coupled between the drain terminal of the first transistor ($M_1$) and ground;
   a second capacitive element ($C_2$) coupled between the gate terminal of the first transistor ($M_1$) and ground; and
   a second transistor ($M_2$) comprising a drain terminal, a source terminal connected to ground and a gate terminal, the gate terminal of the second transistor ($M_2$) being coupled to the gate terminal of the first transistor ($M_1$);
   **characterized in that** the impedance element (R1+L1) includes a resistor ($R_1$) and an inductor ($L_1$) in series.

2. The frequency selective circuit according to claim 1, wherein the source terminal of the first transistor ($M_1$) is coupled to a degeneration resistive element ($R_d$).

**Patentansprüche**

1. Frequenzselektive Schaltung, wobei die frequenzselektive Schaltung aufweist:

   einen ersten Transistor ($M_1$), der einen Senkenanschluss, einen mit Masse verbundenen Quellenanschluss und einen Gatteranschluss aufweist;
   ein Impedanzelement ($R_1$+$L_1$), das zwischen dem Senkenanschluss und dem Gatteranschluss des ersten Transistors ($M_1$) geschaltet ist;

ein erstes kapazitives Element ($C_1$), das zwischen dem Senkenanschluss des ersten Transistors ($M_1$) und der Masse geschaltet ist;
ein zweites kapazitives Element ($C_2$), das zwischen dem Gatteranschluss des ersten Transistors ($M_1$) und der Masse geschaltet ist; und
einen zweiten Transistor ($M_2$), der einen Senkenanschluss, einen mit der Masse verbundenen Quellenanschluss und einen Gatteranschluss aufweist, wobei der Gatteranschluss des zweiten Transistors ($M_2$) mit dem Gatteranschluss des ersten Transistors ($M_1$) verbunden ist;
**dadurch gekennzeichnet, dass** das Impedanzelement ($R_1$+$L_1$) einen Widerstand ($R_1$) und eine Induktivität ($L_1$) in Reihe enthält.

2. Frequenzselektive Schaltung nach Anspruch 1, wobei der Quellenanschluss des ersten Transistors ($M_1$) mit einem Degenerationswiderstandselement ($R_d$) verbunden ist.

## Revendications

1. Circuit sélectif de fréquence, dans lequel le circuit sélectif de fréquence comprend :

un premier transistor ($M_1$) comprenant une borne de drain, une borne de source connectée à la masse et une borne de gâchette ;
un élément d'impédance (R1 + L1) couplé entre la borne de drain et la borne de gâchette du premier transistor ($M_1$) ;
un premier élément capacitif ($C_1$) couplé entre la borne de drain du premier transistor ($M_1$) et la masse ;
un second élément capacitif ($C_2$) couplé entre la borne de gâchette du premier transistor ($M_1$) et la masse ; et
un second transistor ($M_2$) comprenant une borne de drain, une borne de source connectée à la masse et une borne de gâchette, la borne de gâchette du second transistor ($M_2$) étant couplée à la borne de gâchette du premier transistor ($M_1$) ;
**caractérisé en ce que** l'élément d'impédance (R1 + L1) inclut une résistance ($R_1$) et un inducteur ($L_1$) en série.

2. Circuit sélectif de fréquence selon la revendication 1, dans lequel la borne de source du premier transistor ($M_1$) est couplée à un élément résistant à la dégénération ($R_d$).

100

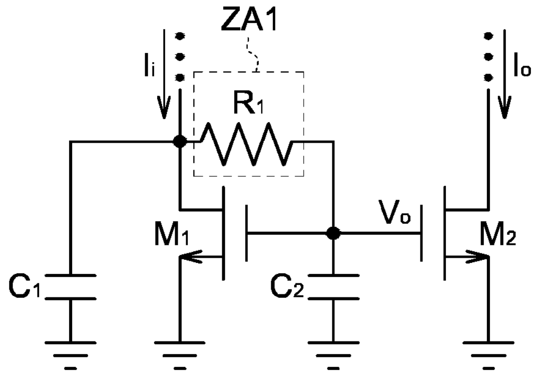


FIG. 1

200

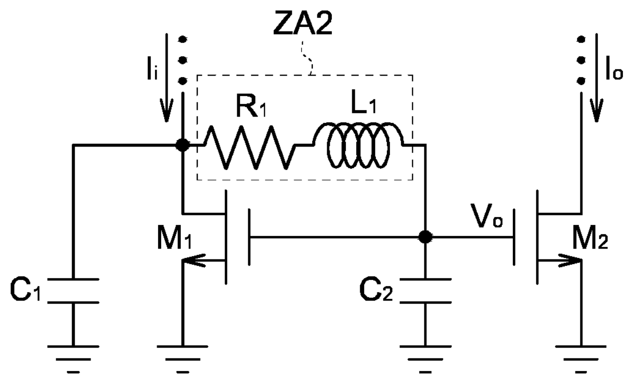


FIG. 2

300

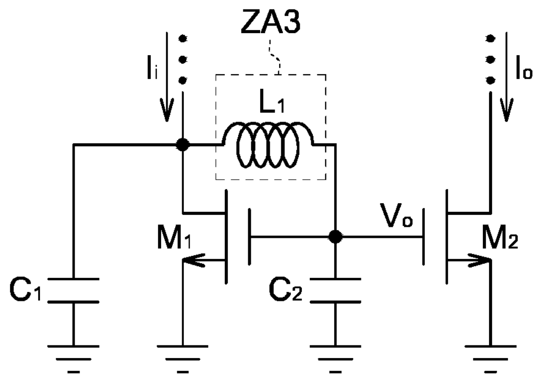


FIG. 3

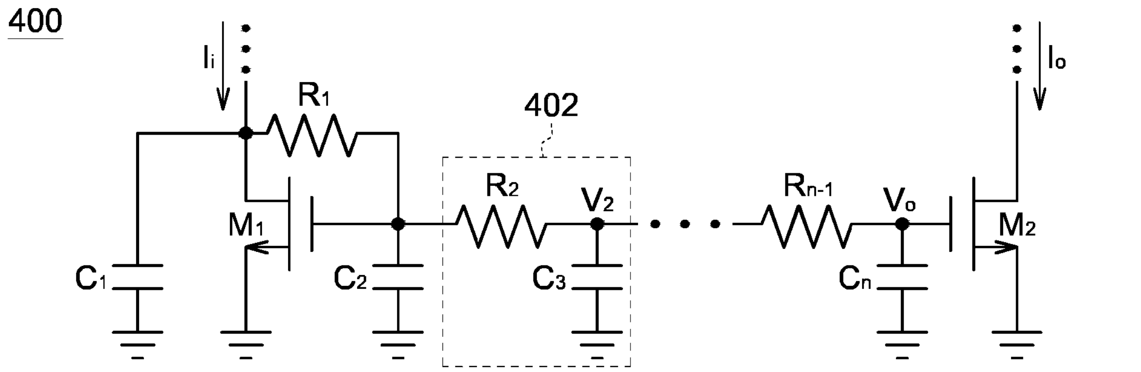


FIG. 4

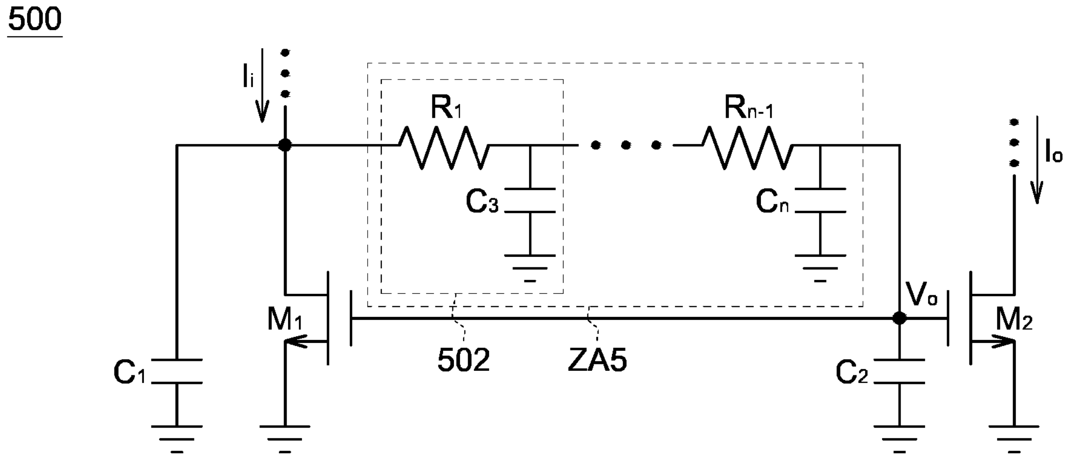


FIG. 5

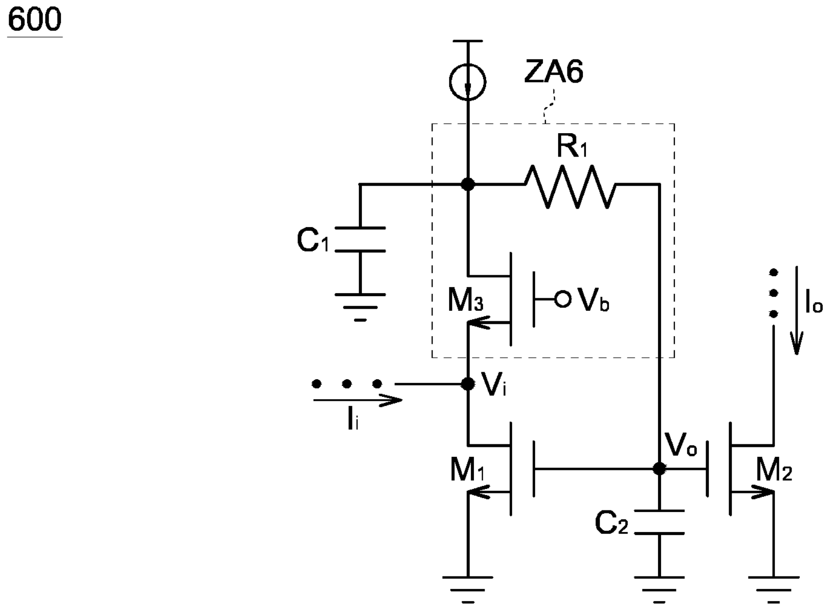


FIG. 6

700

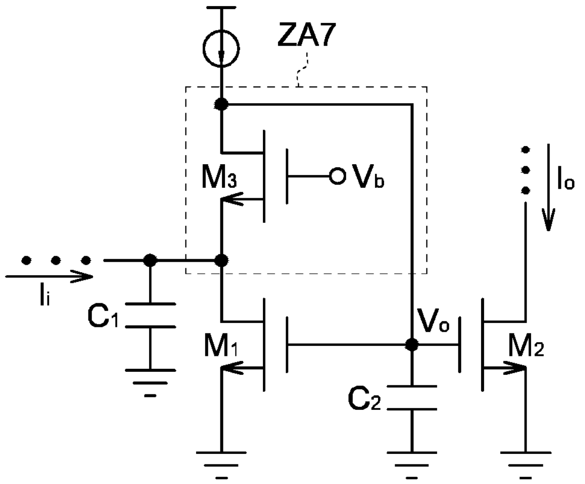


FIG. 7

800

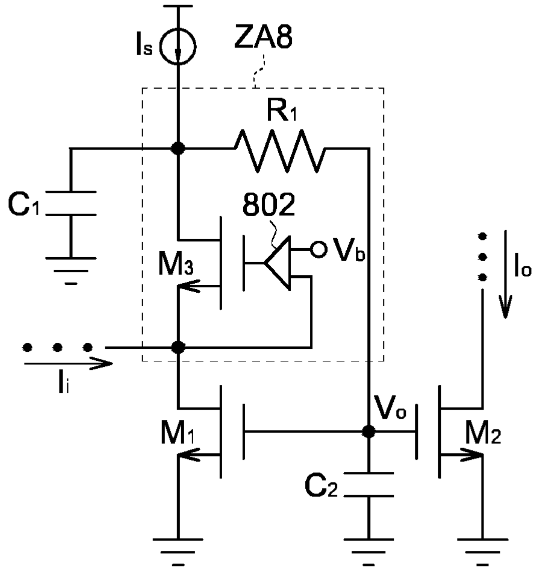


FIG. 8

900

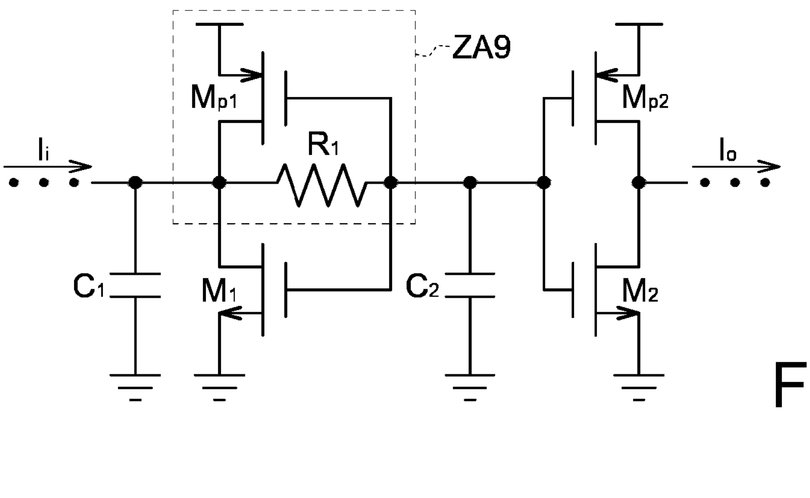


FIG. 9

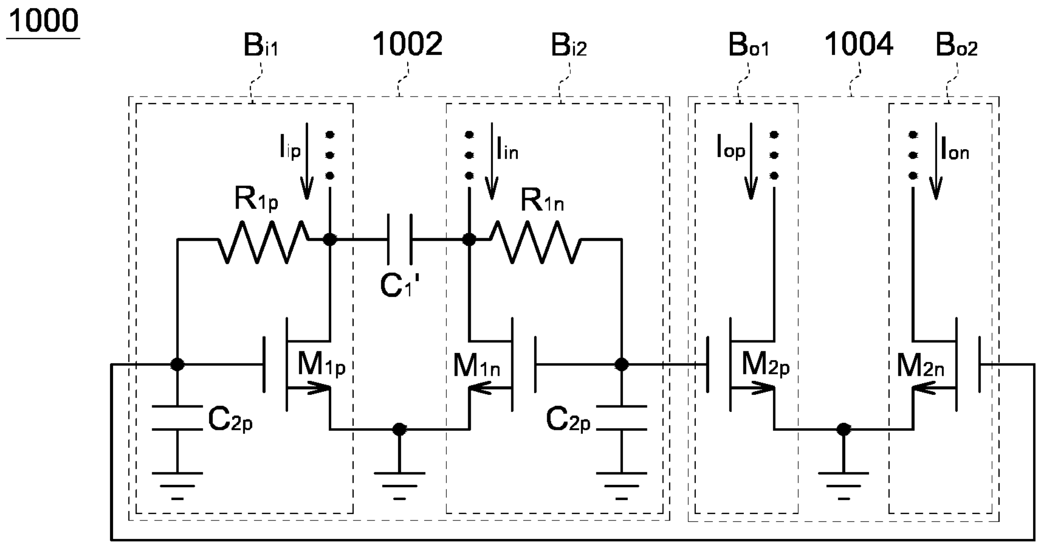
1000
$B_{i1}$
1002
$B_{i2}$
$B_{o1}$
1004
$B_{o2}$
$I_{ip}$
$I_{in}$
$I_{op}$
$I_{on}$
$R_{1p}$
$R_{1n}$
$C_1'$
$M_{1p}$
$M_{1n}$
$M_{2p}$
$M_{2n}$
$C_{2p}$
$C_{2p}$

FIG. 10

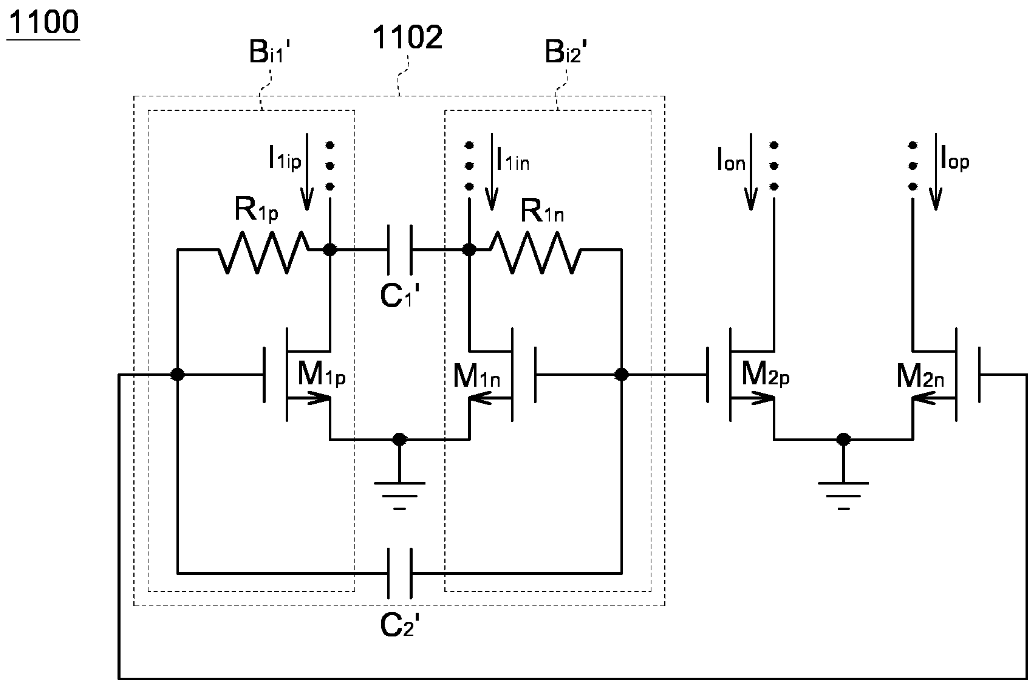
1100
$B_{i1}'$
1102
$B_{i2}'$
$I_{1ip}$
$I_{1in}$
$I_{on}$
$I_{op}$
$R_{1p}$
$R_{1n}$
$C_1'$
$M_{1p}$
$M_{1n}$
$M_{2p}$
$M_{2n}$
$C_2'$

FIG. 11

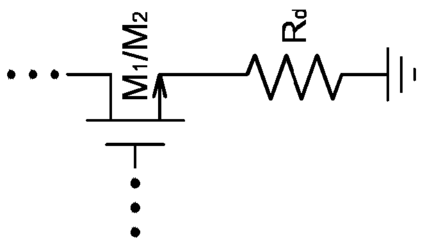


FIG. 12A

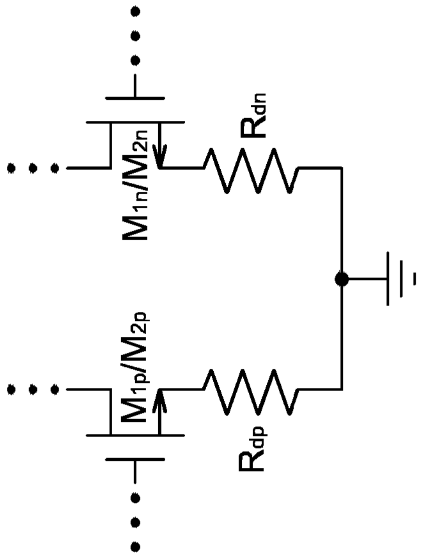


FIG. 12B

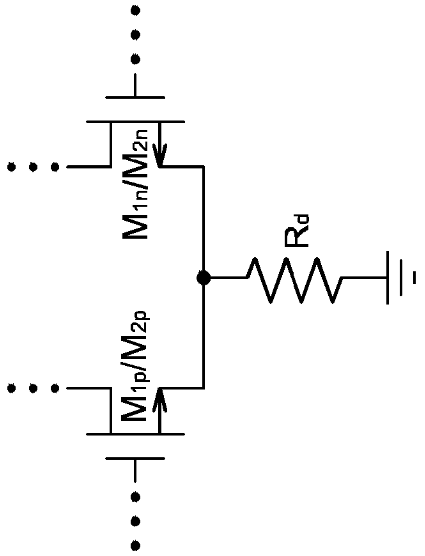


FIG. 12C

1300

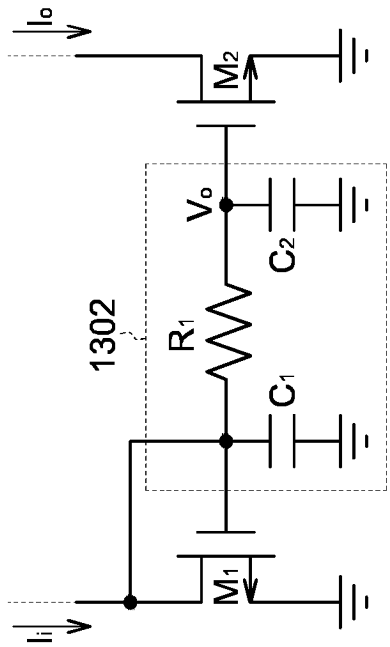


FIG. 13

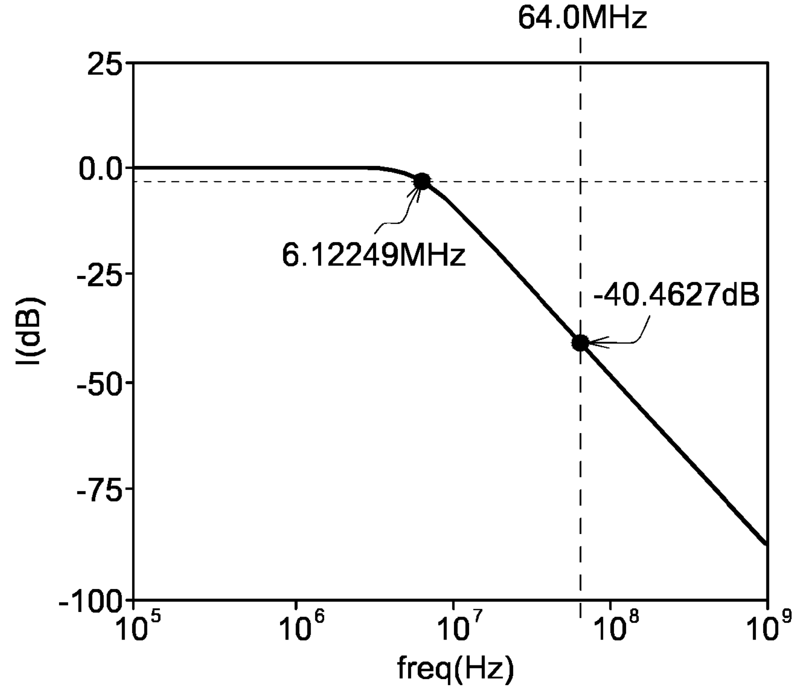


FIG. 14A

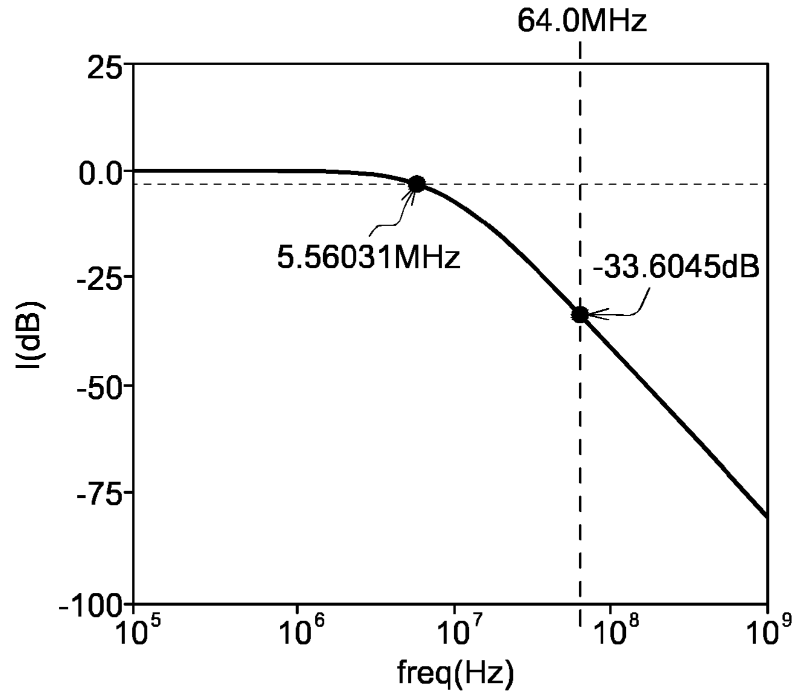


FIG. 14B

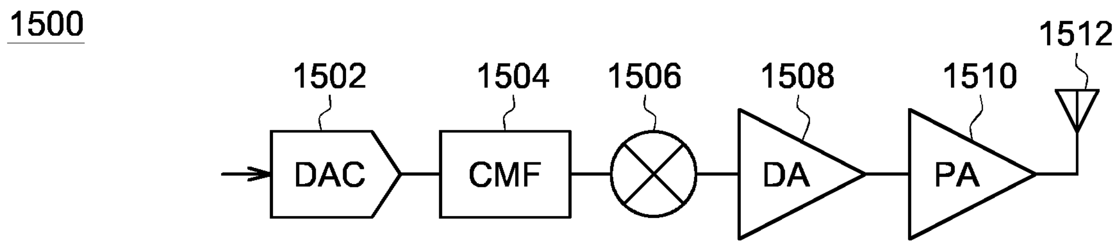


FIG. 15

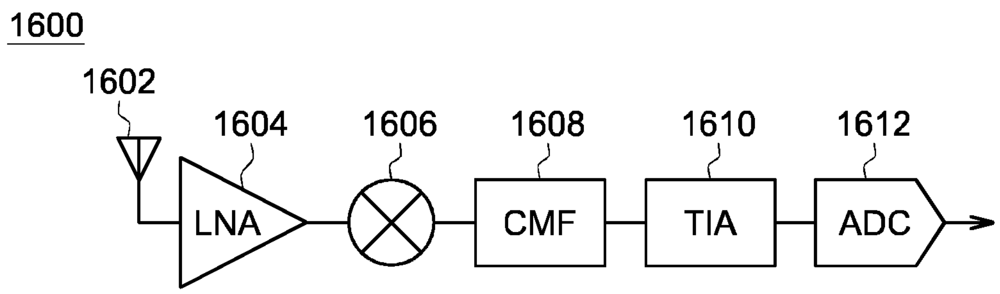


FIG. 16

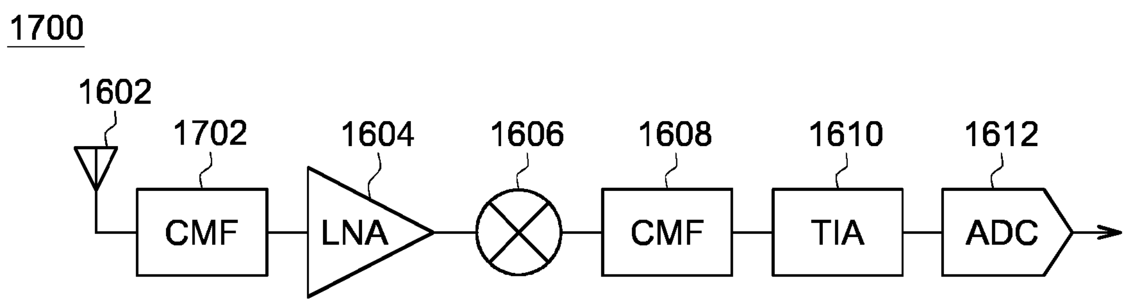


FIG. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2011090824 A1
- US 20120098574 A1


### Non-patent literature cited in the description


- Compact Implementation of high-performance CMOS current mirror. Electronics Letters. IEE, 2005, vol. 41
- CMOS transconductance amplifiers, architectures and active filters: a tutorial. IEE Proceedings: Circuits Devices and Systems. Institution of Electrical Engineers, 2000, vol. 147